(19) Europäisches Patentamt
European Patent Office
Office européen des brevets

(11) **EP 1 405 410 B1**

(12) **EUROPÄISCHE PATENTSCHRIFT**

(45) Veröffentlichungstag und Bekanntmachung des Hinweises auf die Patenterteilung:
**10.10.2007 Patentblatt 2007/41**

(21) Anmeldenummer: **02729900.7**

(22) Anmeldetag: **21.05.2002**

(51) Int Cl.:
**H03H 3/04** *(2006.01)* **H03H 9/17** *(2006.01)*

(86) Internationale Anmeldenummer:
**PCT/DE2002/001836**

(87) Internationale Veröffentlichungsnummer:
**WO 2003/005576 (16.01.2003 Gazette 2003/03)**

(54) **FREQUENZABSTIMMBARER RESONATOR**

FREQUENCY-TUNABLE RESONATOR

RESONATEUR POUVANT ETRE SYNTONISE EN FREQUENCE

(84) Benannte Vertragsstaaten:
**DE FR GB IT**

(30) Priorität: **03.07.2001 DE 10132181**

(43) Veröffentlichungstag der Anmeldung:
**07.04.2004 Patentblatt 2004/15**

(73) Patentinhaber: **EPCOS AG**
**81669 München (DE)**

(72) Erfinder: **STÖMMER, Ralph**
**85579 Neubiberg (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**US-A- 4 719 383** **US-A- 5 801 476**

• **PATENT ABSTRACTS OF JAPAN vol. 007, no. 196 (P-219), 26. August 1983 (1983-08-26) & JP 58 095221 A (OLYMPUS KOGAKU KOGYO KK), 6. Juni 1983 (1983-06-06)**

**Beschreibung**

Mit akustischen Wellen arbeitende Volumenschwinger, sogenannte FBAR - (Thin-film-bulk-acoustic-resonator) oder auch BAW-Resonatoren (Bulk-acoustic-wave) genannt, basieren auf einem piezoelektrischen Grundkörper, der an zwei Hauptoberflächen mit je einer Elektrode versehen ist. Ein solcher Resonator weist eine Resonanzfrequenz fr auf, die nach der Formel

$$fr = v/2L_0$$

von der zwischen den Elektroden bemessenen Dicke $L_0$ des Grundkörpers abhängig ist. Mit v ist dabei die Geschwindigkeit der Longitudinalwelle im piezoelektrischen Grundkörper bezeichnet. Solche, beispielsweise aus der US 4 719 383 bekannten, Resonatoren können beispielsweise zum Aufbau von HF-Filtern verwendet werden. Die in diesem Frequenzbereich erforderliche Schichtdicke des Grundkörpers im μm-Bereich macht Dünnschichtverfahren zur Herstellung der Grundkörper erforderlich. Um die FBAR-Resonatoren für HF-Filter zu verwenden und eine hohe Ausbeute zu erreichen, ist eine hohe Homogenität der Schichtdicke mit einer maximalen Abweichung von weniger als 0,3% erforderlich, um sowohl eine scharfe Resonanzfrequenz als auch die Lage der Resonanzfrequenz an der gewünschten Stelle zu erhalten. Mit den heute verfügbaren Schichtabscheidetechniken läßt sich diese Schichtdickenhomogenität auf Substraten mit Durchmessern größer 150 mm jedoch nicht erreichen.

Es existieren zwar Verfahren, eine mit Dünnschichttechnik hergestellte Schicht durch nachträgliches Trimmen (= nachträgliche Korrektur der Schichtdicke und damit der Resonanzfrequenz) so zu behandeln, bis eine gewünschte Schichtdicke in einer gewünschten Homogenität erhalten wird. Diese Verfahren umfassen dabei zusätzliches Abscheiden von Material oder nachträgliches Materialabtragen. Für eine rentable Massenfertigung sind diese Verfahren jedoch noch nicht ausgereift genug und außerdem teuer.

Um einen FBAR-Resonator auf eine gewünschte Resonanzfrequenz zu stimmen, sind heutzutage im wesentlichen zwei Wege bekannt. Wenn es für einzelne Anwendungen in geringem Umfang wirtschaftlich verantwortbar ist, können die Resonatoren wie eben erläutert einzeln durch nachträgliche Schichtabscheidung oder nachträgliche Ionenstrahlätzung auf eine gewünschte Resonanzfrequenz getrimmt werden. Alternativ können die Resonatoren durch eine äußere Netzwerkanpassung mit externen elektrischen Schaltelementen, insbesondere mit L- und C-Gliedern versehen werden, um die gewünschte Resonanzfrequenz $f_r$ einzustellen. Dies ist jedoch mit einem hohen Stückpreis für das Filter verbunden und außerdem nur durchführbar, wenn das Filtervolumen keine für die Anwendung in der Telekommunikation, als Sensorelement und in Steuerschaltungen kritische Größe darstellt.

Aufgabe der vorliegenden Erfindung ist es daher, einen Resonator anzugeben, der mit einfachen Mitteln auf eine gewünschte Resonanzfrequenz abstimmbar ist.

Diese Aufgabe wird erfindungsgemäß durch einen Resonator mit den Merkmalen von Anspruch 1 gelöst. Vorteilhafte Ausgestaltungen der Erfindung sowie Verfahren zur Frequenzabstimmung eines Resonators sind weiteren Ansprüchen zu entnehmen.

Erfindungsgemäß wird vorgeschlagen, im Grundkörper des Resonators neben der zur Schwingung anregbaren piezoelektrischen Schicht zusätzlich eine halbleitende Schicht vorzusehen, die eine gegenüber der piezoelektrischen Schicht höhere elektrische Leitfähigkeit eines ersten Leitfähigkeitstyps aufweist. Auf den beiden Hauptoberflächen des Grundkörpers sind je eine Elektrodenschicht vorgesehen, die Anschlüsse zum Anlegen einer elektrischen Spannung aufweist. Durch Anlegen einer elektrischen Spannung an einen solchen Resonator wird in einem solchen Grundkörper durch Diffusion von Ladungsträgern die Dicke der Schottky-Raumladungszone gesteuert, womit sich die Leitfähigkeit und damit die Dielektrizitätskonstante erheblich verändert. Eine solche Raumladungszone verhält sich gegenüber einer longitudinalen akustischen Welle anders als die halbleitende Schicht und liefert einen Dickenbeitrag zu der die Resonanzfrequenz bestimmenden aktiven Schichtdicke des Grundkörpers. Mithin wird durch Anlegen einer Spannung im erfindungsgemäßen Resonator die aktive Schichtdicke erhöht, was zu einer Veränderung der Resonanzfrequenz führt. Daher ist der erfindungsgemäße Resonator durch Anlegen einer äußeren Spannung an die Elektroden in seiner Resonanzfrequenz veränderbar.

Die Erfindung stellt mit einfachen Mitteln einen Resonator zur Verfügung, der ohne aufwendige Trimmverfahren und ohne aufwendige externe Schaltelemente auf eine gewünschte Resonanzfrequenz einstellbar ist. Bei geringen Spannungsänderungen besteht eine nahezu lineare Abhängigkeit der Resonanzfrequenzänderung von der angelegten Spannung. Die Polarität der angelegten Spannung bestimmt dabei die Richtung der Frequenzverschiebung, wobei allgemein gilt, daß eine Vergrößerung der Raumladungszone zu einer höheren Resonanzfrequenz, eine Verkleinerung der Raumladungszone zu einer niedrigeren Resonanzfrequenz führt.

Die halbleitende Schicht ist dabei vorzugsweise zwischen der piezoelektrischen Schicht und einer Elektrode angeordnet. Sie ist von einem ersten Leitfähigkeitstyp und p- oder n-leitend eingestellt. Je nach verwendetem Halbleiter wird die Leitfähigkeit über eine Dotierung oder über eine Veränderung der Normstöchiometrie der halbleitenden Verbindung eingestellt.

Vorzugsweise wird für die piezoelektrische Schicht ein Material verwendet, in dem sich durch Dotierung oder Veränderung der Stöchiometrie halbleitende Eigenschaften und damit eine höhere Leitfähigkeit einstellen läßt. Mit wachsender elektrischer Leitfähigkeit gehen dabei die piezoelektrischen Eigenschaften verloren. Wird ein solches entsprechend halbleitend eingestelltes, ursprünglich piezoelektrisches Material für die halbleitende Schicht verwendet, so vergrößert sich bei Anlegen einer Spannung geeigneter Polarität die Raumladungszone in der halbleitenden SChicht, die sich dann in ihren Eigenschaften wieder der piezoelektrischen Schicht annähert. Die Veränderung der Resonanzfrequenz ist dann von der Veränderung der Dicke der Raumladungszone abhängig. Die Relation zwischen der Dickenveränderung der Raumladungszone und der Schichtdicke der piezoelektrischen Schicht bestimmt das Ausmaß, um das die Resonanzfrequenz verschiebbar ist.

Die Materialgleichheit von piezoelektrischer und halbleitender Schicht ermöglicht eine besonders einfache Herstellung des erfindungsgemäßen Resonators. Die halbleitende Schicht kann dann einfach durch Veränderung der Abscheidebedingungen oder durch Dotierung der piezoelektrischen Schicht während der Schichterzeugung mit Dünnschichtverfahren oder durch nachträgliche Dotierung der piezoelektrischen Schicht in einen oberflächennahen Schichtbereich des Grundkörpers hergestellt werden. Das einheitliche bzw. nahezu einheitliche Material des Grundkörpers bewirkt außerdem eine hohe mechanische Stabilität, stabile Schwingungseigenschaften und vermeidet Grenzflächenprobleme zwischen halbleitender und piezoelektrischer Schicht, sowie zwischen Halbleiterschicht und Elektroden.

Sieht man von technischen Problemen bei der Schichterzeugung ab, so können grundsätzlich auch verschiedene Materialien für die piezoelektrische Schicht und die halbleitende Schicht verwendet werden.

In einer vorteilhaften Ausgestaltung der Erfindung weist der Grundkörper des Resonators eine Struktur auf, die einer pin-Diode ähnelt. Dazu ist zusätzlich zur ersten halbleitenden Schicht vom ersten Leitfähigkeitstyp auf der gegenüberliegenden Oberfläche der piezoelektrischen Schicht eine zweite halbleitende Schicht vom entgegengesetzten (zweiten) Leitfähigkeitstyp angeordnet. Eine solche "pin-Struktur" hat den Vorteil, daß sich durch Diffusion von Ladungsträgern von einer halbleitenden Schicht des ersten Leitfähigkeitstyps in die halbleitende Schicht vom entgegengesetzten Leitfähigkeitstyp von selbst eine Diffusionsspannung und damit eine Raumladungszone, also eine an Majoritätsladungsträgern verarmte Zone ausbildet. Die Diffusion kommt zum Erliegen, sobald die dabei entstehende Diffusionsspannung einer weiteren Verschiebung der Majoritätsladungsträgern entgegenwirkt. Dabei entsteht eine natürliche Raumladungszone, die sich in ihrer Dicke durch die außen anzulegende Spannung verändern läßt. Die anzulegende äußere Spannung kann dabei so gepolt werden, daß sie additiv zu der sich selbst einstellenden Diffusionsspannung die bestehende Dicke der Raumladungszone vergrößert. In gleicher Weise ist auch eine Dickenreduktion der Verarbeitungszone durch entsprechend entgegengesetzt gepolte äußere Spannungen möglich. Die pin-Struktur hat dabei den Vorteil, daß die Kombination eines ersten Leitfähigkeitstyps mit einem entgegengesetzten zweiten Leitfähigkeitstyp und einem dazwischengeschalteten, gering leitfähigen piezoelektrischen Material nicht unerhebliche Diffusionsspannungen im Voltbereich erzeugt. Damit ist, im Falle anliegender hochfrequenter Wechselspannungen, Durchbruchsicherheit und Frequenzstabilität des Resonators gewährleistet. Die Höhe der in Sperrichtung anlegbaren äußeren Spannung ist unbegrenzt. Möglich ist es selbstverständlich, daß auch die piezoelektrische Schicht eine geringe Leitfähigkeit aufweist, wobei die Majoritätsladungsträger vom ersten oder zweiten Leitfähigkeitstyp sein können.

In einer weiteren vorteilhaften Ausgestaltung der Erfindung ist beiderseits der piezoelektrischen Schicht jeweils eine halbleitende Schicht vorgesehen, wobei beide halbleitende Schichten vom gleichen Leitfähigkeitstyp sind. Der erfindungsgemäße Resonator weist dann in Anlehnung an die Nomenklatur entsprechender Dioden eine nin oder eine pip Struktur auf. Ein solcher Resonator weist an den Grenzflächen zwischen halbleitenden Schichten und piezoelektrischer Schicht (bei pip Struktur), oder an den Grenzflächen zwischen halbleitenden Schichten und Elektroden (bei nin Struktur) zwei sich selbst einstellende Raumladungszonen auf, deren Dicke durch eine anzulegende äußere Spannung erhöht oder reduziert werden kann. Wird die piezoelektrische Schicht mittels Kontaktierung ebenfalls mit einer Elektrode versehen und die äußere Spannung als symmetrisch auf beide Raumladungszonen wirkende Sperrspannung angelegt, so ergibt sich im Vergleich zur pin Struktur der Vorteil, daß die Gesamtdicke der beiden Raumladungszonen auch bei der während des Betriebs des Resonators angelegten hochfrequenten Wechselspannung großer Amplitude stets konstant bleibt. In einer pin Struktur könnte die Dicke der Verarmungszone bei hochfrequenter Wechselspannung großer Amplitude variieren.

Soll der Resonator in einem mobilen und beispielsweise von einem Akkumulator betriebenen elektrischen Gerät eingesetzt werden, etwa in einer Filteranwendung für ein schnurloses Kommunikationsgerät, so wird mit pin, pip und nin Strukturen bereits mit üblichen Akkumulatorspannungen von bis zu 3 V eine ausreichende Frequenzverschiebung von beispielsweise 4000 ppm erzielt. Die Diffusion von Ladungsträgern, also von Elektronen und Löchern in der piezoelektrischen Schicht ist möglich, da diese üblicherweise eine geringe Restleitfähigkeit aufgrund zufälliger Dotierungen oder Verschmutzungen aufweist.

Mit der Erfindung wird ein kostengünstiger Resonator von geringem Flächenbedarf erhalten, der beispielsweise mit der Spannungsversorgung handelsüblicher Handys betrieben werden kann. Die Frequenzabstimmung über die angelegte äußere Spannung kann dazu verwendet werden, gleichartige Resonatoren gleicher Resonanzfrequenz zu verwenden, um diese durch unterschiedliche äußere Spannungen auf unterschiedliche Resonanzfrequenzen einzustellen. Möglich ist es jedoch auch, erfindungsgemäße Resonatoren, die aufgrund von Fertigungstoleranzen unterschiedliche Resonanzfrequenzen aufweisen, mit Hilfe einer äußeren Spannung auf den gewünschten ggf. einheitlichen Wert nachzuregeln. Dies vereinfacht zusätzlich die Fertigung, da die erlaubten Toleranzwerte für Schichtdickenschwankungen innerhalb unterschiedlicher Fertigungslose erheblich verbessert werden. Gegenüber bekannten frequenzabstimmbaren Bauelementen wird ein im Platzbedarf wesentlich verbessertes Bauelement erhalten, das außerdem als einzelnes Bauelement verwirklicht ist. Dadurch wird zusätzlich Raum eingespart, was für die Miniaturisierung tragbarer Geräte wie beispielsweise Handys zusätzlich von Bedeutung ist.

Bevorzugte Materialien für die piezoelektrische Schicht, die durch entsprechende Variation der Stöchiometrie oder durch Dotierung mit halbleitenden Eigenschaften versehen werden können, sind dem entsprechend Zinkoxid, Aluminiumnitrid, Galliumnitrid, Indiumnitrid, Siliziumcarbid, Galliumarsenid oder Cadmiumsulfid. Prinzipiell sind auch weitere, hier nicht aufgezählte piezoelektrische Materialien mit halbleitenden Eigenschaften geeignet. Für diese Materialien sind auch die Dotierstoffe zur Erzeugung der entsprechenden Leitfähigkeitstypen bekannt. Zur Erzeugung einer p-Leitfähigkeit ist bei Zinkoxid beispielsweise Mangan, Wasserstoff, Lithium, Natrium oder Kalium geeignet. Eine n-Leitfähigkeit wird hier durch Aluminium, Gallium, Indium oder Zinksulfid erzielt. Für Aluminiumnitrid sind als p-Dotierstoffe Magnesium, Zink, Cadmium oder Kohlenstoff bekannt, während Silizium zur Erzeugung einer n-Leitfähigkeit dienen kann. Bei Galliumnitrid werden die p-Dotierstoffe Magnesium, Zink, Kadmium und Kohlenstoff verwendet, ebenso als n-Dotierstoff Silizium. Für Galliumarsenid sind Germanium, Beryllium und Zink zur Erzeugung einer p-Dotierung bekannt. Eine n-Dotierung kann dabei mit Zinn, Schwefel und Tellur erzeugt werden. In allen diesen Stoffen läßt sich eine Leitfähigkeit auch durch Veränderung der Stöchiometrie, also durch Veränderung des Atomverhältnisses der binären Stoffe einstellen. Eine solche Einstellung läßt sich in einfacher Weise durch Änderung der Abscheideparameter bei den entsprechenden Dünnschichtverfahren erzielen, oder durch Veränderung des Verhältnisses der Ausgangsstoffe.

Als Elektrodenmaterialien sind herkömmliche Elektrodenmaterialien geeignet wie beispielsweise Molybdän, Titan, Wolfram, Aluminium, Gold und Platin. Ggf. eine gesonderte Auswahl gilt für die herstellungsbedingt erste und damit untere Elektrode, da diese als Basis für die Dünnschichtabscheidung von halbleitender und piezoelektrischer Schicht dient. Bewährt haben sich dabei erste Elektrodenschichten aus Molybdän, Wolfram, Gold oder Aluminium.

Bei der Auswahl unterschiedlicher Materialien für die piezoelektrische und die halbleitenden Schichten wird vorzugsweise auf eine Verträglichkeit der Schichten geachtet, beispielsweise auf übereinstimmende mechanische Parameter, insbesondere auf ähnliche Ausdehnungskoeffizienten und Kristallparameter. Auch ist zu beachten, daß eine unterschiedliche obere Schicht gut und homogen auf der ersten unteren Schicht aufwächst. Ggf. ist es möglich, zwischen beiden Schichten zur Anpassung der Eigenschaften eine neutrale Bufferschicht vorzusehen, die dann allerdings mit einer ausreichenden elektrischen Leitfähigkeit zu versehen ist.

Die Ladungsträgerkonzentration in der halbleitenden Schicht kann auf einen Bereich von $10^{14}$ bis $10^{21}$ Ladungsträger pro $cm^3$ eingestellt werden. Ist die halbleitende Schicht ursprünglich eine piezoelektrische Schicht, die nur durch die Dotierung zur halbleitenden Schicht wird, so gilt generell, daß die piezoelektrischen Eigenschaften mit zunehmender Leitfähigkeit abnehmen. Der untere Bereich der Ladungsträgerdichte liegt dabei nahe der intrinsischen Ladungsträgerdichte $n_i$, also der Ladungsträgerdichte, die auch in einem "nicht leitenden" piezoelektrischen Material vorhanden ist. Zum Beispiel liegt die intrinsische Ladungsträgerdichte $n_i$ von piezoelektrischem Zinkoxid bei etwa $10^{12}$ pro $cm^3$. Je höher die Majoritätsladungsträgerdichte der halbleitenden Schicht ist, desto größer ist auch die Diffusionsspannung, die sich im Falle eines Bauelements mit pin-, pip- oder nin-Struktur einstellt. Eine höhere Diffusionsspannung bewirkt eine dickere Raumladungszone und eröffnet dabei prinzipiell die Möglichkeit, durch Anlegen einer geeignet gepolten Spannung die Dicke der Verarmungszone zu verändern. Mithin wird durch veränderbare Dotierkonzentrationen und veränderbare Normstöchiometrie in der halbleitenden Schicht das Regelintervall des erfindungsgemäßen Resonators verändert.

Ein weiterer Parameter, der das Regelintervall des erfindungsgemäßen Resonators bestimmt, ist die Dicke der halbleitenden Schichten. Vorteilhaft wird diese zwischen 10 und 500 nm eingestellt. Im allgemeinen gilt, daß mit der Dicke der halbleitenden Schicht auch die maximale relative Frequenzverschiebung $\Delta f_{max}/f_0$ ansteigt. Die Dicke der piezoelektrischen Schicht ist üblicherweise jedoch nicht frei wählbar, da sie der frequenzbestimmende Bestandteil eines BAW-Resonators ist und daher in Abhängigkeit von der gewünschten Frequenz einen festen vorgegebenen Wert aufweist.

Im folgenden wird die Erfindung anhand von Ausführungsbeispielen und der dazugehörigen neun Figuren näher erläutert.

Figur 1 zeigt einen erfindungsgemäßen Resonator im schematischen Querschnitt.

Figur 2 zeigt den typischen Admittanzverlauf eines Resonators

Figur 3 zeigt exemplarisch die Abhängigkeit der Dicke der Raumladungszone von der angelegten äußeren Spannung für eine pin Struktur.

Figur 4 zeigt exemplarisch die relative Resonanzfrequenzänderung $\Delta f/f_0$ in Abhängigkeit von der angelegten äußeren Spannung für eine pin Struktur.

Figuren 5 und 6 zeigen im schematischen Querschnitt weitere erfindungsgemäße Resonatoren mit pip Struktur nin Struktur.

Figur 7 zeigt exemplarisch die relative Resonanzfrequenzänderung $\Delta f/f_0$ in Abhängigkeit von der angelegten äußeren Spannung.

Figur 8 zeigt anhand von Admittanzkurven beispielhafte Resonanzfrequenzverschiebungen.

Figur 9 zeigt exemplarisch das elektronische Ersatzschaltbild von erfindungsgemäßen Resonatoren mit pin, pip und nin Struktur.

Als erstes Ausführungsbeispiel wird ein BAW-Resonator auf der Basis von Zinkoxid ZnO als piezoelektrisches Material hergestellt. Der Aufbau eines solchen Resonators erfolgt dabei bis auf die Herstellung der halbleitenden Schichten nach prinzipiell bekannten Verfahren, wie sie beispielsweise aus einem Artikel von K. M. Lakin at all, Microwave Symposium Digest, IEEE MTT-S International 1995, Seiten 838 bis 886 zu entnehmen sind.

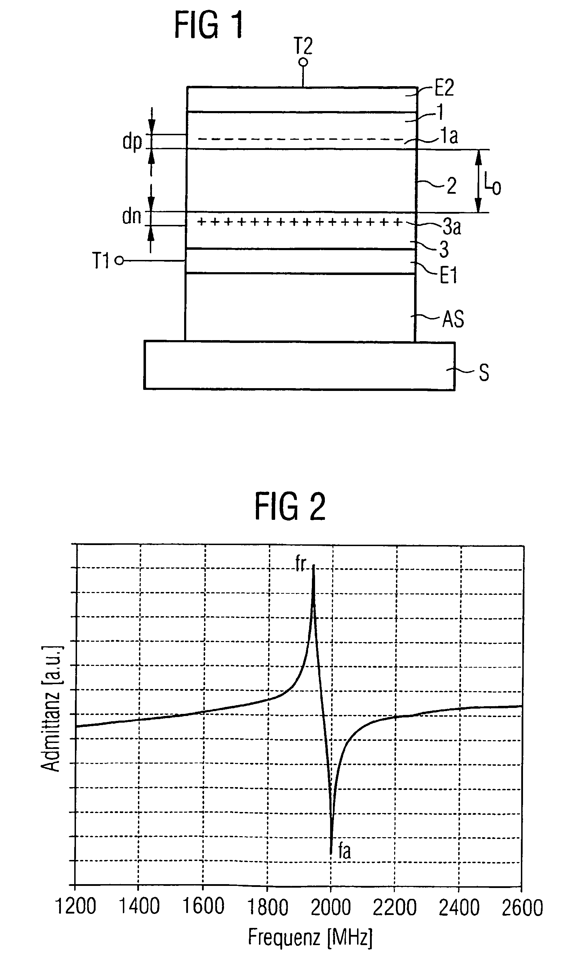

Figur 1: Als Substrat kann beispielsweise ein Siliziumsubstrat verwendet werden. Möglich sind jedoch auch andere Trägermaterialien wie Glas, SiC, SiGe, InP, GaAs, Saphir oder andere. Um akustische Verluste in das Substratmaterial zu vermeiden, kann der Resonator entweder als Brückenstruktur ausgeführt werden, wobei zwischen unterster Elektrode E1 und Substratmaterial S ein Luftspalt angeordnet ist. Möglich ist es jedoch auch, insbesondere wie es in Figur 1 dargestellt ist, zwischen Substrat und unterster Elektrode einen akustischen Spiegel AS vorzusehen. Dieser läßt sich in einfacher Weise aus Lambda-Viertel-Schichten fertigen, beispielsweise aus alternierenden Schichten von Wolfram und Siliziumoxid, Wolfram und Silizium, Aluminiumnitrid und Siliziumoxid, Silizium und Siliziumoxid, Molybdän und Siliziumoxid oder andere Kombinationen von Materialien, die unterschiedliche akustische Impedanz aufweisen und sich in Dünnschichttechniken wechselseitig übereinander abscheiden lassen.

Bei Verwendung von Wolfram und Siliziumoxid, einer Kombination mit hoher akustischer Impedanzdifferenz, erweisen sich zwei Paare von Lambda-Viertelschichten als ausreichend, um nahezu 100% der akustischen Welle zu reflektieren. Bei Verwendung von Wolfram und Silizium und Siliziumoxid, einer Kombination mit geringer akustischer Impedanzdifferenz, werden wenigstens fünfzehn Paare von Lambda-Viertelschichten benötigt, um nahezu 100% der akustischen Welle zu reflektieren.

Über dem akustischen Spiegel AS wird nun die erste Elektrode E1 erzeugt, beispielsweise durch Aufsputtern von Gold, Aluminium, Wolfram oder Molybdän. Als alternative Aufbringverfahren sind auch CVD-Verfahren oder Aufdampfverfahren geeignet. Für einen bei z.B. 2 GHz arbeitenden Resonator werden beispielsweise 200 nm Aluminium aufgesputtert. Über der ersten Elektrode E1 wird eine erste Halbleiterschicht 3 erzeugt, beispielsweise eine 50 nm dicke n-dotierte Zinkoxidschicht. Dazu kann zunächst undotiertes Zinkoxid durch Sputtern oder CVD-Verfahren aufgebracht und anschließend dotiert werden. Zur n-Dotierung sind die Elemente Aluminium, Gallium oder Indium geeignet. Möglich ist es auch, Zinksulfid als n-leitenden Dotierstoff einzubringen, vorzugsweise jedoch durch Codeposition während der Schichtherstellung. Eine weitere Alternative ist es, den Sauerstoffgehalt während der Abscheidung von Zinkoxid zu erhöhen, wobei sich ein sauerstoffreicheres und damit n-leitend modifiziertes Zinkoxid erzeugen läßt. Die Dotierung erfolgt in einer Höhe von ca. $10^{14}$ bis $10^{21}$ pro $cm^3$, beispielsweise in einer Stärke von $10^{17}$ $cm^{-3}$.

Über der ersten Halbleiterschicht 3 wird nun die eigentliche Resonatorschicht, die piezoelektrische Schicht 2 erzeugt. Vorzugsweise wird die undotierte Zinkoxidschicht 2 mit dem gleichen Verfahren erzeugt, wie die erste halbleitende Schicht, die n-dotierte Zinkoxidschicht 3. Je nach Abscheidebedingungen kann die piezoelektrische Schicht 2 mit einer Ladungsträgerkonzentration von $10^{11}$ bis $10^{12}$ $cm^{-3}$ und damit einer geringen intrinsischen Leitfähigkeit abgeschieden werden. Mit dieser Ladungsträgerkonzentration wird ein gut isolierendes Zinkoxid erhalten, welches jedoch noch ausreichend Leitfähigkeit zeigt, um die genannte Ladungsträgerdiffusion in der Zinkoxidschicht zu ermöglichen. Die Zinkoxidschicht 2 zeigt gute piezoelektrische Eigenschaften.

Als zweite halbleitende Schicht wird darüber nun eine dünne Schicht p-leitenden Zinkoxids erzeugt, beispielsweise durch direkte Abscheidung dotierten Materials oder durch Erzeugung eines sauerstoffarmen Zinkoxids, welches aufgrund der Sauerstoffarmut p-leitende Eigenschaften aufweist. Möglich ist es jedoch auch, die piezoelektrische Schicht 2 entsprechend dikker zu erzeugen und einen oberen Schichtbereich durch nachträgliches Dotieren in eine halbleitende Schicht 1 umzuwandeln. Entscheidend ist dabei, daß die Tiefe der Dotierung ausreichend kontrolliert wird, um eine klar definierte Schichtdicke der piezoelektrischen Schicht zu gewährleisten, die wie bereits erwähnt den frequenzbestimmenden Parameter des Resonators darstellt. Bevorzugt sind daher Herstellungsverfahren, bei denen die zweite halbleitende Schicht 1 bereits in dotierter Form erzeugt wird. Dadurch lassen sich schärfere Grenzflächen erzeugen.

Über der zweiten halbleitenden Schicht 1 wird nun die obere Elektrode E2 erzeugt, welche wieder aus einem herkömmlichen Elektrodenmaterial ausgeführt sein kann, vorzugsweise jedoch das gleiche Material wie die erste Elektrode E1 umfaßt und beispielsweise aus einer 200 nm dicken Aluminiumschicht aufgebaut ist.

Mit T1 und T2 sind elektrische Anschlüsse zum Anlegen einer Spannung und/oder eines HF-Signals vorgesehen, die mit erster und zweiter Elektrode E1, E2 verbunden sind.

Figur 2 zeigt den typischen Admittanzverlauf eines Resonators, wie er sowohl für bekannte als auch für erfindungsgemäße Resonatoren beobachtet wird.

In dem die Schichten 1, 2 und 3 umfassenden Grundkörper erfolgt nun ohne äußere Antriebskräfte eine Diffusion von Ladungsträgern von einer Halbleiterschicht zur anderen, insbesondere von Elektronen aus der ersten Halbleiterschicht 3 in die zweite Halbleiterschicht 1 und von Löchern aus der zweiten Halbleiterschicht 1 in die erste Halbleiterschicht 3. Die diffundierten Ladungsträger reichern sich in mehr oder wenig dicken Raumladungszonen 3a und 1a beiderseits der piezoelektrischen Schicht 2 an und kompensieren die dort vorhandenen primären Ladungsträger vom jeweils entgegengesetzten Typ. In den Raumladungszonen sind dann praktisch keine freien Ladungsträger mehr vorhanden. Die Dicke der Raumladungszonen dp und dn ist dabei abhängig von der Höhe der Dotierung, von der Dicke der halbleitenden Schichten und von der Dicke der piezoelektrischen Schicht. Die gesamte Dicke d der Raumladungszonen ergibt sich dabei als Summe der einzelnen Raumladungszonen dp und dn: d = dp + dn.

Durch Anlegen einer Spannung an die Anschlüsse T1 und T2 kann nun die aufgrund der Ladungsträgerdiffusion entstandene Diffusionsspannung $V_D$ verstärkt oder abgeschwächt werden, wobei sich die Dicke der Raumladungszonen je nach Polarität der angelegten Spannung verringert oder erhöht. Die aus einer angelegten äußeren Spannung U resultierende Gesamtdicke d der Verarmungszonen ergibt sich aus der Gleichung

$$d = \sqrt{L_0{}^2 + \frac{2\varepsilon_0\varepsilon_r}{e_0}\left(\frac{1}{N_d}+\frac{1}{N_a}\right)(V_d+U)} \;-\; L_0$$

In dieser Gleichung ist $V_D$ die Diffusionsspannung, $L_0$ die ursprüngliche Dicke der piezoelektrischen Schicht 2, $N_d$ und $N_a$ die Dotierungsdichten des Donors in der n-dotierten Halbleiterschicht 3 bzw. im Akzeptor der p-dotierten Halbleiterschicht 1. $e_0$ ist die Elementarladung des Elektrons, während $\varepsilon_0$ und $\varepsilon_r$ die dielektrische und relative dielektrische Konstante der halbleitenden Schicht darstellen.

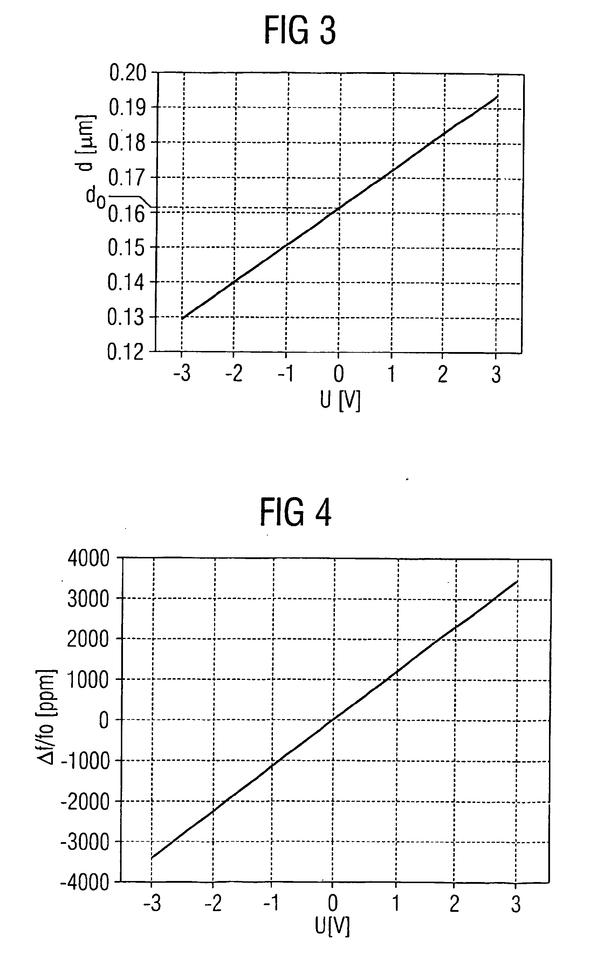

Figur 3 zeigt das Verhalten der Dicke d der Verarmungszone gegen den Wert der angelegten äußeren Spannung U für den Resonator in pin Struktur. Dabei ergibt sich für geringe Änderungen ein annähernd lineares Verhalten der Dicke d von der Spannung U.

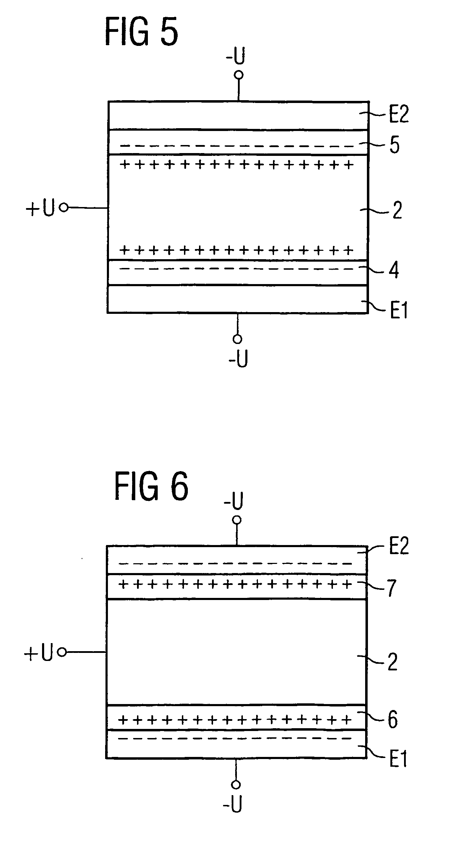

Figur 4 zeigt, daß die relative Frequenzänderung $\Delta f/f_0$, also das Verhältnis der Frequenzänderung zur Mittenfrequenz annähernd linear ist. Die Figuren 3 und 4 zeigen auch, daß die Linearität auch für angelegte äußere Spannung in Durchlaßrichtung gilt, sofern die Spannung den Betrag der Diffusionsspannung eines Resonators in pin Struktur nicht übersteigt. Damit ist gewährleistet, daß die effektive Spannung, gebildet aus der Summe von Diffusionsspannung und angelegter äußerer Spannung stets in Sperrichtung zeigt.

In einer weiteren Untersuchung wird überprüft, in wie weit die übrigen Eigenschaften des Resonators im erfindungsgemäßen Resonator beeinträchtigt sind. Über die spezifischen Widerstände der halbleitenden Schichten und der piezoelektrischen Schicht kann zusammen mit deren Schichtdicken der Spannungsabfall über die einzelnen Schichten dargestellt werden. Für einen wie in Figur 1 ausgebildeten erfindungsgemäßen Resonator werden beispielsweise folgende Materialparameter angenommen. Die Aluminium umfassenden Elektroden weisen einen spezifischen Widerstand von $2{,}7 \times 10^{-6}$ Ohm x cm auf. Der entsprechende Wert für die p- und n-dotierten Zinkoxydschichten (erste und zweite halbleitende Schicht) beträgt 1 Ohm x cm bei einer Dotierung von $4 \times 10^{23}$ m$^{-3}$ und einer Ladungsträgerbeweglichkeit von 15 cm$^2$/Vs. Der spezifische Widerstand des piezoelektrischen Zinkoxyds wird zu $10^5$ Ohm cm bestimmt. Damit fallen die Diffusionsspannungen $V_D$ und die zusätzlich angelegte Spannung U im wesentlichen an den Verarmungszonen 1a und 3a sowie an der piezoelektrischen Schicht 2 ab.

Da die volle Spannung am piezoelektrisch wirksamen Schichtbereich (piezoelektrische Schicht + Verarmungszone) anliegt, ist auch die Resonatorfunktion dieses Schichtbereiches nicht beeinträchtigt.

In einer weiteren Untersuchung wird abgeschätzt, inwieweit die halbleitenden und damit auch elektrisch leitenden Schichten einen Rauschbeitrag im Resonator erzeugen. Ein solcher könnte entstehen, wenn erzeugte Ladungen durch den Grundkörper zur jeweiligen Gegenelektrode diffundieren und dort einen zusätzlichen Strombeitrag, den Rauschbeitrag liefern. Eine entsprechende Abschätzung zeigt jedoch, daß dieser zusätzliche Rauschbeitrag gegenüber dem nicht vermeidbaren Leckstromanteil optimaler piezoelektrischer Schichten vernachlässigbar gering ist, wenn der erfindungsgemäße Resonator in Sperrrichtung betrieben wird. Daraus wird klar, daß der erfindungsgemäße Resonator wie ein herkömmlicher BAW-Resonator für Hochfrequenzfilteranwendungen geeignet ist.

In einer weiteren Untersuchung wird abgeschätzt, in wie weit die quasi freien Ladungen innerhalb der halbleitenden Schichten einem an die Elektroden E1 und E2 angelegten hochfrequenten Wechselfeld Energie entziehen können. Ein solcher Energieentzug würde zu einer Dämpfung der akustischen Longitudinalwelle innerhalb des Resonators führen und dabei zu schlechteren Resonanzeigenschaften führen. Für die viskose Dämpfung erhält man eine komplexe Abhängigkeit, bei der im wesentlichen die relative Dielektrizitätskonstante des betrachteten Materials die variierbare Variable darstellt. Diese wiederum hängt von der Ladungsträgerdichte N ab. Wird die Dämpfung in Abhängigkeit von der Ladungsträgerdichte N bestimmt, so erhält man ein ausgeprägtes Maximum bei einem Wert von N =

0,004 x $10^{17}$ cm$^{-3}$. An diesem Maximum ist die Absorption ca. 100 x höher als die von undotiertem Zinkoxid, also vom piezoelektrischen Material. Gegenüber der Absorption von Aluminium ist das Maximum ca. 13 x höher, dagegen nur 5 x höher als die Absorption von Gold, welches ein gängiges Elektrodenmaterial für Resonatoren darstellt. Mit der für die halbleitenden Schichten gewählten Dotierung von 4 x $10^{17}$ cm$^{-3}$ erhält man eine Ladungsträgerdichte, die mit der angelegten Spannung U um etwa 2 Größenordnungen schwankt. Damit entspricht die Absorption in den p-dotierten und n-dotierten Zinkoxidschichten (Halbleiterschichten 1 und 3) höchstens der Absorption einer gleich dicken Goldschicht, welche in gewöhnlichen BAW-Resonatoren als Elektrode Verwendung findet. Die zusätzliche Absorption erfindungsgemäßer Resonatoren ist daher gegenüber der in herkömmlichen Resonatoren gering.

Figur 5 zeigt ein Ausführungsbeispiel der Erfindung, bei der der Resonator durch entsprechende halbleitende Schichten eine pip Struktur aufweist. Mit Hilfe einer zusätzlichen Elektrode E3 an der piezoelektrischen Schicht 2, die in der pip Struktur die i-Schicht darstellt, können die p-dotierten halbleitenden Schichten 4 und 5 gegen die piezoelektrische Schicht 2 vorgespannt werden, wobei eine negative Vorpolung der halbleitenden Schichten 4 und 5 (wie in der Figur durch die angegebene Polarität dargestellt) zu einer Erhöhung der Sperrspannung führt. Mit der Höhe der angelegten äußeren Spannung variiert die Dicke der Raumladungszonen, die sich an den beiden Grenzflächen zwischen den halbleitenden Schichten 4 und 5 und der piezoelektrischen Schicht 2 ausbilden. Die Raumladungszonen sind durch die eingezeichneten Vorzeichen der geladenen Gebiete der Raumladungszonen dargestellt.

Figur 6 zeigt ein weiteres Ausführungsbeispiel der Erfindung, bei der der Resonator durch entsprechende n-dotierte, halbleitende Schichten 6 und 7 eine nin Struktur aufweist. Hierbei sei hervorgehoben, daß sich die Raumladungszonen zwischen der halbleitenden Schicht 6 und der Metallelektrode E1 sowie zwischen der halbleitenden Schicht 7 und der Metallelektrode E2 ausbilden (Metall-Halbleiter-Schottky-Kontakt). Mit Hilfe einer zusätzlichen Elektrode E3 an der piezoelektrischen Schicht 2, die in der pip Struktur die i-Schicht darstellt, können die halbleitenden Schichten 6 und 7 gegen die Metallelektroden E1 und E2 vorgespannt werden, wobei auch hier eine negative Vorpolung der Metallelektroden E1 und E2 (wie in der Figur durch die angegebene Polarität dargestellt) zu einer Erhöhung der Sperrspannung führt. Mit der Höhe der angelegten äußeren Spannung variiert die Dicke der Raumladungszonen. Die Raumladungszonen sind auch hier durch die eingezeichneten Vorzeichen der geladenen Gebiete der Raumladungszonen dargestellt.

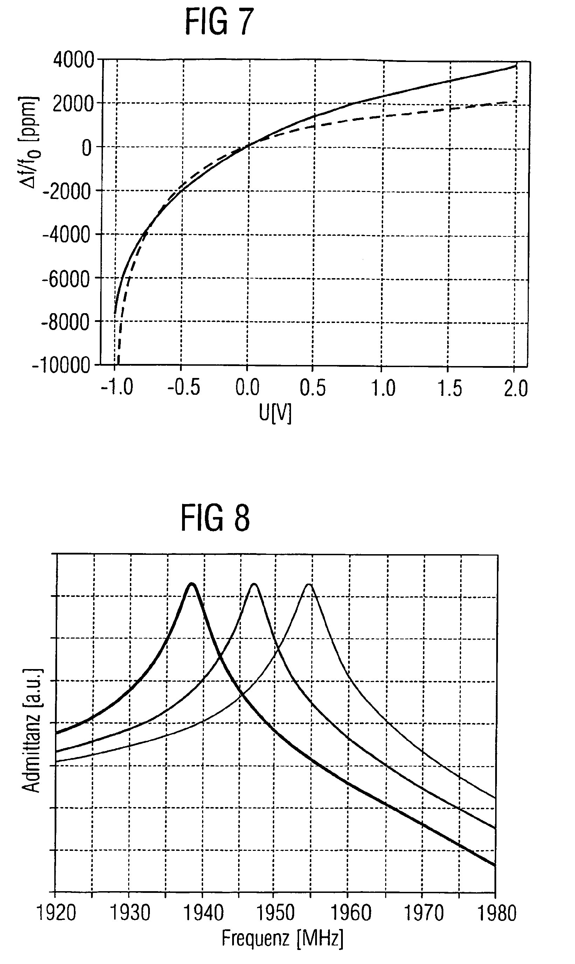

Figur 7 zeigt für Resonatoren in nin Struktur exemplarisch die berechnete hier nicht lineare Abhängigkeit der relativen Resonanzfrequenzverschiebung von der angelegten Spannung U. Dabei steht die durchgezogene Linie für eine Dotierdichte $10^{17}$ pro cm$^3$, die gestrichelte Linie für eine Dotierdichte $10^{15}$ pro cm$^3$. Daraus erkennt man, daß über geeignete Dotierdichten in gewissen Grenzen Regelintervalle einstellbar sind. Zusätzlich kann die Regelung der Resonanzfrequenz mit verschiedenen Empfindlichkeiten erfolgen, die sich jeweils aus dem Verhältnis von Resonanzfrequenzintervall zu Spannungsintervall ergibt und der Steigung des Kurvenverlaufs entspricht. Für Resonatoren in pip Struktur wird ein prinzipiell ähnliches Verhalten berechnet, wobei lediglich die für eine Verschiebung erforderlichen Spannungen variieren.

Figur 8 zeigt exemplarisch anhand einer spezifischen Ausgestaltung eines Resonators in nin Struktur die Admittanzkurven des Resonators ohne und mit angelegten unterschiedlichen, äußeren Spannungen. Die dabei erzielten Resonanzfrequenzverschiebungen betragen -4100ppm von 1947MHz zu 1939MHz, bzw. +4100ppm von 1947MHz zu 1955 MHz. Die unterschiedlichen Richtungen der Verschiebung werden dabei jeweils durch unterschiedliche Polarität der angelegten äußeren Spannung erreicht. Ein gleiches Bild wird für Resonatoren in pip Struktur beobachtet, wobei hier die jeweils erforderlichen Spannungen anders zu wählen sind.

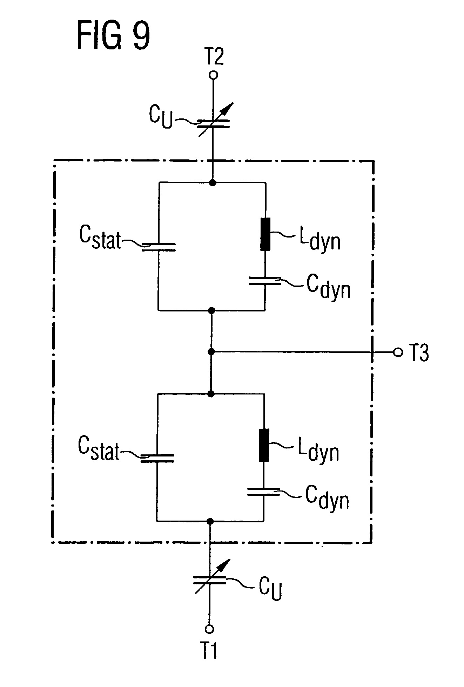

In Figur 9 ist das elektronische Ersatzschaltbild des mittels halbleitender Schichten frequenzabstimmbaren Resonators in pin, pip und nin Struktur aufgezeigt. Dabei ist der Resonator in seiner ohne halbleitende Schicht nicht frequenzabstimmbaren Form durch die Glieder $L_{dyn}$ und $C_{dyn}$ sowie $C_{stat}$ gegeben (mit gestrichelter Linie umgebene Elemente). $L_{dyn}$ und $C_{dyn}$ bezeichnen die dynamische Induktivität und die dynamische Kapazität des BAW Resonators, $C_{stat}$ bezeichnet die statische Kapazität des Resonators. Spannungsgesteuerte Raumladungszonen, die durch Einführung halbleitender Schichten in den BAW Resonator die Frequenzabstimmbarkeit ermöglichen, sind im Ersatzschaltbild durch die spannungsabhängige zusätzliche Kapazität $C_U$ berücksichtigt. T1 und T2 geben die elektrischen Anschlüsse zu Anlegen einer Spannung und/oder eines HF Signals wieder, T3 ist die Elektrode an der piezoelektrischen Schicht für Resonatoren in nin und pip Struktur. Die Höhe der von außen angelegten Spannung U verkleinert oder vergrößert die Dicke der Raumladungszone d, wodurch sich die spannungsabhängige Kapazität $C_U$ invers dazu vergrößert oder verkleinert. Im Ersatzschaltbild ist der einfache Zusammenhang zwischen relativer Resonanzfrequenzverschiebung $\Delta f/f_0$ und spannungsabhängiger Kapazität $C_U$ gegeben durch die Gleichung

$$\frac{\Delta f}{f_0} = \sqrt{1 + \left(\frac{fa^2}{fr^2} - 1\right)\left(\frac{1}{1 + \frac{C_U}{C_{stat}}}\right)} - 1$$

fr und fa bezeichnen hierbei die Resonanzfrequenz und die Antiresonanzfrequenz des frequenzabstimmbaren Resonators.

Obwohl die Erfindung in den Ausführungsbeispielen nur anhand einer konkreten Struktur beschrieben wurde, ist sie nicht auf diese begrenzt. Vielmehr führen alle Kombinationen von piezoelektrischen Schichten und halbleitenden Schichten zu erfindungsgemäßen Resonatoren, da sich bei solchen Kombinationen entweder von selbst oder spätestens durch die angelegte äußere Spannung eine Verarmungszone in der halbleitenden Schicht ausbildet, deren Größe spannungsgesteuert ist und die damit die Resonanzfrequenz des Resonators beeinflußt. Damit ist auch die Auswahl des für die piezoelektrische Schicht geeigneten Materials praktisch unbegrenzt, ebenso wie die Auswahl des Materials für die halbleitende Schicht. Bevorzugt sind jedoch Kombinationen von piezoelektrischer Schicht und halbleitender Schicht auf der selben Materialbasis, wobei die halbleitenden Eigenschaften durch entsprechende Dotierung oder Abwandlung der Stöchiometrie eingestellt werden. Weitere Parameter sind die Schichtdickenverhältnisse der beteiligten Schichten sowie die Höhe der Dotierungen bzw. die Höhe der Ladungsträgerkonzentration in den halbleitenden Schichten.

Erfindungsgemäße Resonatoren können als einstellbare Frequenzgeber verwendet werden. Bevorzugt können sie als Reaktanzelemente in Paßbandfiltern in Abzweigtechnik, z.B. mit ladder-type Struktur eingesetzt werden. Möglich ist auch eine Anwendung der Resonatoren in Sensoren, bei der eine äußere physikalische Größe auf die Resonanzfrequenz einwirkt und die Frequenzverschiebung ein Maß für die Größe darstellt. Durch erfindungsgemäße Nachregelung der Resonanzfrequenz kann eine einfache Bestimmung der zu messenden Größe über die Nachregelspannung erfolgen.

## Patentansprüche

1.  Frequenzabstimmbarer Resonator mit den Merkmalen:

    - es ist ein eine piezoelektrische Schicht (2) umfassender Grundkörper mit zwei zueinander parallelen Hauptoberflächen vorgesehen,
    - in der Nähe einer der Hauptoberflächen ist im Grundkörper eine erste halbleitende Schicht (3,4,6) mit einer gegenüber der piezoelektrischen Schicht höheren elektrischen Leitfähigkeit eines ersten Leitfähigkeitstyps ausgebildet,
    - beide Hauptoberflächen des Grundkörpers sind mit je einer Elektrodenschicht (E1, E2) bedeckt,
    - es sind Mittel (T1, T2, T3; +U, -U) zum Anlegen einer variablen äußeren Vorspannung an die halbleitende Schicht zur Beeinflussung der Dicke (dp,dn) der sich in der halbleitenden Schicht ausbildenden Raumladungszone (3a,1a) vorgesehen,
    - jede der beiden Elektrodenschichten (E1, E2) ist mit einem elektrischen Anschluß (T1$_V$,T2$_V$;T1$_{HF}$,T2$_{HF}$) zum Anlegen einer elektrischen Spannung und/oder eines HF Signals verbunden.

2.  Resonator nach Anspruch 1,
    bei dem die halbleitende Schicht (3,4,6) und die piezoelektrische Schicht (2) das gleiche Material umfassen,
    wobei die halbleitende Schicht im Unterschied zur piezoelektrischen Schicht eine Dotierung oder eine veränderte Stöchiometrie aufweist.

3.  Resonator nach Anspruch 1 oder 2,
    bei dem nahe der der ersten halbleitenden Schicht (3,4,6) gegenüberliegenden Hauptoberfläche eine zweite halbleitende Schicht (1,5,7) mit gegenüber der piezoelektrischen Schicht (2) erhöhter elektrischer Leitfähigkeit vom entgegengesetzten Leitfähigkeitstyp ausgebildet ist,
    wobei der Grundkörper mit den halbleitenden Schichten und der dazwischen liegenden piezoelektrische Schicht die Struktur einer pin Diode aufweist.

4.  Resonator nach Anspruch 1 oder 2,
    bei dem im Grundkörper nahe der der ersten halbleitenden Schicht (3,4,6) gegenüberliegenden Hauptoberfläche eine zweite halbleitende Schicht (1,5,7) mit gegenüber der piezoelektrischen Schicht (2) erhöhter elektrischer Leitfähigkeit vom gleichen Leitfähigkeitstyp ausgebildet ist, bei dem die piezoelektrische Schicht (2) mit einer zusätzlichen Elektrode (E3) verbunden ist.

5. Resonator nach einem der Ansprüche 1 bis 4,
   bei dem das Material der piezoelektrischen Schicht (2) halbleitende Eigenschaften aufweist und ausgewählt ist aus Zinkoxid, Aluminiumnitrid, Galliumnitrid, Indiumnitrid,
   Siliziumcarbid, Galliumarsenid oder Cadmiumsulfid , oder ein anderes piezoelektrisches Material mit halbleitenden Eigenschaften umfaßt.

6. Resonator nach einem der Ansprüche 1 bis 5,
   bei dem die halbleitenden Schichten (1, 3, 4, 5, 6, 7) eine Dotierung oder eine Ladungsträgerdichte im Bereich von $10^{14}$ bis $10^{21}$ $cm^{-3}$ aufweisen.

7. Resonator nach einem der Ansprüche 1 bis 6,
   bei dem der Grundkörper von den halbleitenden Schichten (1,3,4,5,6,7) begrenzt ist und diese eine Dicke von jeweils 10 bis 500nm aufweisen.

8. Resonator nach einem der Ansprüche 1 bis 7,
   bei dem die Dicke der piezoelektrischen Schicht (2) so bemessen ist, daß die Resonanzfrequenz $f_0$ des Resonators im Bereich der für drahtlose Kommunikationssysteme gebräuchlichen Frequenzen von 500 MHz bis 10 GHz liegt.

9. Resonator nach einem der Ansprüche 1 bis 8,
   bei dem die Elektroden (E1,E2,E3) mit einer Spannungsquelle verbunden sind, und bei dem Mittel zur variablen Einstellung der Spannung vorgesehen sind.

10. Verfahren zur elektrischen Frequenzabstimmung eines Bulk Acoustic Wave Resonators - BAW Resonator -, bei dem ein Grundkörper mit zwei auf zueinander parallelen Hauptoberflächen angeordneten Elektroden (E1, E2) vorgesehen wird, der eine piezoelektrische und zwei halbleitende Schichten umfaßt und eine einer pin Diode ähnliche Struktur mit einer Raumladungszone aufweist,
    bei dem die Elektroden mit einer Spannungsquelle verbunden werden,
    bei dem eine Spannung an die Elektroden angelegt wird, so daß sich die Dicke (d) der Raumladungszone um einen Betrag ($\Delta$d) verändert, und wobei die
    sich Resonanzfrequenz des BAW Resonators um einen mit dieser Dicke korrelierenden Betrag $\Delta$f gegenüber dem Zustand ohne angelegte Spannung verändert.

11. Verfahren zur elektrischen Frequenzabstimmung eines Bulk Acoustic Wave Resonators - BAW Resonator -,
    bei dem ein Grundkörper mit zwei auf zueinander parallelen Hauptoberflächen angeordneten Elektroden (E1,E2) vorgesehen wird, der eine piezoelektrische (2)
    und zwei halbleitende Schichten (4,5;6,7) umfaßt und eine einer pip oder einer nin Diode ähnliche Struktur mit Raumladungszonen aufweist,
    bei dem an der piezoelektrischen Schicht eine weitere Elektrode (E3) vorgesehen wird,
    bei dem die Elektroden (E1, E2, E3) mit einer Spannungsquelle verbunden werden,
    bei dem eine Spannung an die Elektroden so angelegt wird, daß in einer pip Struktur die halbleitenden Schichten (4,5) gegen die piezoelektrische Schicht (2) bzw. in einer nin Struktur die halbleitenden Schichten (6,7) gegen die Elektroden (E1, E2) vorgespannt sind, so daß sich die Dicke (d) der Raumladungszone um einen Betrag ($\Delta$d) verändert, und wobei die
    sich Resonanzfrequenz des BAW Resonators um einen mit dieser Dicke korrelierenden Betrag $\Delta$f gegenüber dem Zustand ohne angelegte Spannung verändert.

12. Verfahren nach Anspruch 10 oder 11,
    bei dem die Höhe der Spannung mittels einer variierbaren Spannungsquelle so eingestellt wird, daß die aus der Summe von angelegter äußerer Spannung plus der sich selbst einstellenden Diffusionsspannung resultierende Spannung noch eine Sperrspannung darstellt.

13. Verfahren nach einem der Ansprüche 10 bis 12,
    bei dem die Resonanzfrequenz fr des BAW Resonators ohne angelegte Spannung bestimmt wird,
    bei dem anschließend die Spannung angelegt und so eingestellt wird, daß sich die Resonanzfrequenz fr um einen Betrag $\Delta$f verändert, bis die Resonanzfrequenz den gewünschten Wert $f_0$ angenommen hat, wobei gilt:

$$\Delta f = (fr - f_0)$$

**14.** Verfahren nach einem der Ansprüche 10 bis 13,
bei dem in einem Bauelement eine Vielzahl von bei unterschiedlichen Sollfrequenzen $fr_{0i}$ arbeitenden Resonatoren ($R_i$) vorgesehen wird, wobei bei gleichartigen, gegebenenfalls durch herstellungsbedingte Streuung unterschiedliche Resonanzfrequenzen aufweisenden Resonatoren durch Anlegen einer geeigneten Regelspannung auf den jeweils gewünschten Wert für die Resonanzfrequenz eingestellt werden.

**15.** Verwendung eines Resonators nach einem der Ansprüche 1 bis 9 als Reaktanzelement in einem in Abzweigtechnik aufgebauten Passbandfilter.

**16.** Verwendung eines Resonators nach einem der Ansprüche 1 bis 9 als bezüglich der Resonanzfrequenz einstellbarer Frequenzgeber.

**17.** Verwendung eines Resonators nach einem der Ansprüche 1 bis 9 als Sensor für eine die Schwingung des Resonators beeinflussende physikalische Größe.

**18.** Verwendung nach Anspruch 17, bei der die physikalische Größe die Resonanzfrequenz des Resonators verändert, und bei der die Resonanzfrequenz des Resonators durch Anlegen einer Regelspannung auf die ursprüngliche Resonanzfrequenz nachgeregelt wird, und bei der die Höhe der Regelspannung als Maß für den Wert der physikalischen Größe hergenommen wird.

**Claims**

**1.** Frequency-tunable resonator comprising the following features:

   - a basic body comprising a piezoelectric layer (2) and having two main surfaces parallel to one another is provided,
   - in the vicinity of one of the main surfaces, a first semiconducting layer (3, 4, 6) having a higher electrical conductivity of a first conductivity type by comparison with the piezoelectric layer is formed in the basic body,
   - the two main surfaces of the basic body are covered with a respective electrode layer (E1, E2),
   - means (T1, T2, T3; +U, -U) for applying a variable external bias voltage to the semiconducting layer for implementing the thickness (dp, dn) of the space charge zone (3a, 1a) that forms in the semiconducting layer are provided,
   - each of the two electrode layers (E1, E2) is connected to an electrical terminal ($T1_V$, $T2_V$; $T1_{HF}$, $T2_{HF}$) for application of an electrical voltage and/or of an RF signal.

**2.** Resonator according to Claim 1,
in which the semiconducting layer (3, 4, 6) and the piezoelectric layer (2) comprise the same material, the semiconducting layer having a doping or an altered stoichiometry in contrast to the piezoelectric layer.

**3.** Resonator according to Claim 1 or 2,
in which a second semiconducting layer (1, 5, 7) having an increased electrical conductivity of the opposite conductivity type by comparison with the piezoelectric layer (2) is formed near the main surface opposite to the first semiconducting layer (3, 4, 6),
the basic body with the semiconducting layers and the piezoelectric layer situated in between having the structure of a pin diode.

**4.** Resonator according to Claim 1 or 2,
in which a second semiconducting layer (1, 5, 7) having an increased electrical conductivity of the same conductivity type by comparison with the piezoelectric layer (2) is formed in the basic body near the main surface opposite to the first semiconducting layer (3, 4, 6),
in which the piezoelectric layer (2) is connected to an additional electrode (E3).

**5.** Resonator according to one of Claims 1 to 4,

in which the material of the piezoelectric layer (2) has semiconducting properties and is selected from zinc oxide, aluminium nitride, gallium nitride, indium nitride, silicon carbide, gallium arsenide or cadmium sulphide, or some other piezoelectric material having semiconducting properties.

6. Resonator according to one of Claims 1 to 5,
in which the semiconducting layers (1, 3, 4, 5, 6, 7) have a doping or a charge carrier density within the range of $10^{14}$ to $10^{21}$ $cm^{-3}$.

7. Resonator according to one of Claims 1 to 6,
in which the basic body is delimited by the semiconducting layers (1, 3, 4, 5, 6, 7) and the latter have a thickness of 10 to 500 nm in each case.

8. Resonator according to one of Claims 1 to 7,
in which the thickness of the piezoelectric layer (2) is dimensioned in such a way that the resonant frequency $f_0$ of the resonator lies within the range of the frequencies from 500 MHz to 10 GHz customary for wireless communication systems.

9. Resonator according to one of Claim 1 to 8,
in which the electrodes (E1, E2, E3) are connected to a voltage source, and in which means for variably setting the voltage are provided.

10. Method for the electrical frequency tuning of a bulk acoustic wave resonator - BAW resonator -,
in which a basic body with two electrodes (E1, E2) arranged on main surfaces that are parallel to one another is provided, which comprises a piezoelectric layer and two semiconducting layers and has a structure with a space charge zone that is similar to a pin diode,
in which the electrodes are connected to a voltage source,
in which a voltage is applied to the electrodes, such that the thickness (d) of the space charge zone changes by a magnitude ($\Delta$d), and the resonant frequency of the BAW resonator changing by a magnitude $\Delta$f, which correlates with said thickness, by comparison with the state without applied voltage.

11. Method for the electrical frequency tuning of a bulk acoustic wave resonator - BAW resonator -,
in which a basic body with two electrodes (E1, E2) arranged on main surfaces that are parallel to one another is provided, which comprises a piezoelectric layer (2) and two semiconducting layers (4, 5; 6, 7) and has a structure with space charge zones that is similar to a pip diode or an nin diode,
in which a further electrode (E3) is provided at the piezoelectric layer,
in which the electrodes (E1, E2, E3) are connected to a voltage source,
in which a voltage is applied to the electrodes in such a way that the semiconducting layers (4, 5) are biased relative to the piezoelectric layer (2) in a pip structure, or the semiconducting layers (6, 7) are biased relative to the electrodes (E1, E2) in an nin structure, such that the thickness (d) of the space charge zone changes by a magnitude ($\Delta$d), and the resonant frequency of the BAW resonator changing by a magnitude $\Delta$f, which correlates with said thickness, by comparison with the state without applied voltage.

12. Method according to Claim 10 or 11,
in which the voltage level is set by means of a variable voltage source in such a way that the voltage resulting from the sum of applied external voltage plus the diffusion voltage that is set automatically still constitutes a reverse voltage.

13. Method according to one of Claims 10 to 12,
in which the resonant frequency fr of the BAW resonator without applied voltage is determined,
in which the voltage is subsequently applied and set in such a way that the resonant frequency fr changes by a magnitude $\Delta$f until the resonant frequency has assumed the desired value $f_0$, where the following holds true:

$$\Delta f = (fr - f_0).$$

14. Method according to one of Claims 10 to 13,
in which a multiplicity of resonators ($R_i$) operating at different desired frequencies $fr_{0i}$ are provided in a component,
in which case, in the case of resonators of identical type which have different resonant frequencies, if appropriate, as a result of production-dictated variation, these are set to the respectively desired value for the resonant frequency by application of a suitable control voltage.

15. Use of a resonator according to one of Claims 1 to 9 as a reactance element in a passband filter constructed using branching technology.

16. Use of a resonator according to one of Claims 1 to 9 as a frequency generator that can be set with regard to the resonant frequency.

17. Use of a resonator according to one of Claims 1 to 9 as a sensor for a physical quantity that influences the oscillation of the resonator.

18. Use according to Claim 17, in which the physical quantity changes the resonant frequency of the resonator, and in which the resonant frequency of the resonator is readjusted to the original resonant frequency by application of a control voltage, and in which the level of the control voltage is taken as a measure of the value of the physical quantity.


**Revendications**

1. Résonateur accordable en fréquence ayant les caractéristiques:

   - il est prévu un corps de base comprenant une couche (2) piézoélectrique et ayant deux surfaces principales parallèles l'une à l'autre ;
   - il est constitué à proximité de l'une des surfaces principales dans le corps de base une première couche (3, 4, 6) semi-conductrice ayant une conductivité électrique d'un premier type de conductivité plus grande que celle de la couche piézoélectrique;
   - les deux surfaces principales du corps de base sont revêtues, respectivement, d'une couche (E1, E2) d'électrode ;
   - il est prévu des moyens (T1, T2, T3 ; +U, -U) d'application d'une tension de polarisation extérieure variable à la couche semi-conductrice pour influer sur l'épaisseur (dp, dn) de la zone (3a, 1a) de charge d'espace se formant dans la couche semi-conductrice ;
   - chacune des deux couches (E1, E2) d'électrode est reliée à une borne (T1$_V$, T2$_V$; T1$_{HF}$, T2$_{HF}$) électrique pour l'application d'une tension électrique et/ou d'un signal HF.

2. Résonateur suivant la revendication 1, dans lequel la couche (3, 4, 6) semi-conductrice et la couche (2) piézoélectrique comprennent le même matériau, la couche semi-conductrice ayant, à la différence de la couche piézoélectrique, un dopage ou une stoechiométrie modifiée

3. Résonateur suivant la revendication 1 ou 2, dans lequel il est formé à proximité de la surface principale opposée à la première couche (3, 4, 6) semi-conductrice une deuxième couche (1, 5, 7) semi-conductrice ayant une conductivité électrique d'un type de conductivité opposée plus grande que celle de la couche (2) piézoélectrique ; le corps de base ayant les couches semi-conductrices et la couche piézoélectrique entre elles ayant la structure d'une diode pin.

4. Résonateur suivant la revendication 1 ou 2, dans lequel il est formé dans le corps de base, à proximité de la surface principale opposée à la première couche (3, 4, 6) semi-conductrice, une deuxième couche (1, 5, 7) semi-conductrice ayant une conductivité électrique du même type de conductivité plus grande que celle de la couche (2) piézoélectrique, dans lequel la couche (2) piézoélectrique est reliée à une électrode (E3) supplémentaire.

5. Résonateur suivant l'une des revendications 1 à 4, dans lequel le matériau de la couche (2) piézoélectrique a des propriétés semi-conductrices et est choisi parmi l'oxyde de zinc, le nitrure d'aluminium, le nitrure de gallium, le nitrure d'indium, le carbure de silicium, l'arséniure de gallium ou le sulfure de cadmium ou comprend un autre matériau piézoélectrique ayant des propriétés semi-conductrices.

**6.** Résonateur suivant l'une des revendications 1 à 5,
dans lequel les couches (1, 3, 4, 5, 6, 7) semi-conductrices ont un dopage ou une densité de porteurs de charge compris entre $10^{14}$ et $10^{21}$ cm$^{-3}$.

**7.** Résonateur suivant l'une des revendications 1 à 6,
dans lequel le corps de base est délimité par les couches (1, 3, 4, 5, 6, 7) semi-conductrices et celles-ci ont une épaisseur de, respectivement, 10 à 500 nm.

**8.** Résonateur suivant l'une des revendications 1 à 7,
dans lequel l'épaisseur de la couche (2) piézoélectrique est telle que la fréquence $f_0$ de résonance du résonateur est dans la plage des fréquences allant de 500 MHz à 10 GHz habituelles pour les systèmes de communication sans fil.

**9.** Résonateur suivant l'une des revendications 1 à 8,
dans lequel les électrodes (E1, E2, E3) sont reliées à une source de tension et dans lequel il est prévu des moyens pour régler de manière variable la tension.

**10.** Procédé d'accord électrique en fréquence d'un Bulk Acoustic Wave Resonator - Résonateur BAW,
dans lequel il est prévu un corps de base ayant deux électrodes (E1, E2) disposées sur des surfaces principales parallèles l'une à l'autre qui comprend une couche piézoélectrique et deux couches semi-conductrices et une structure analogue à une diode pin ayant une zone de charge d'espace ;
dans lequel les électrodes sont reliées à une source de tension ;
dans lequel il est appliqué une tension aux électrodes de sorte que l'épaisseur (d) de la zone de charge d'espace se modifie d'un montant ($\Delta$d) ; et
dans lequel la fréquence de résonance du résonateur BAW se modifie d'un montant $\Delta$f corrélé à cette épaisseur par rapport à l'état sans tension appliquée.

**11.** Procédé d'accord électrique en fréquence d'un Bulk Acoustic Wave Resonator - Résonateur BAW,
dans lequel il est prévu un corps de base ayant deux électrodes (E1, E2) disposées sur des surfaces principales parallèles l'une à l'autre qui comprend une couche (2) piézoélectrique et deux couches (4, 5 ; 6, 7) semi-conductrices et une structure analogue à une diode pin ayant une zone de charge d'espace ;
dans lequel il est prévu une autre électrode (3) sur la couche piézoélectrique ;
dans lequel les électrodes (E1, E2, E3) sont reliées à une source de tension ;
dans lequel il est appliqué une tension aux électrodes de manière à ce que, dans une structure pip, les couches (4, 5) semi-conductrices soient polarisées par rapport à la couche (2) piézoélectrique ou dans une structure nin, les couches (6, 7) soient polarisées par rapport aux électrodes (E1, E2) de sorte que l'épaisseur (d) de la zone de charge d'espace se modifie d'un montant ($\Delta$d) ; et
dans lequel la fréquence de résonance du résonateur BAW se modifie d'un montant $\Delta$f corrélé à cette épaisseur par rapport à l'état sans tension appliquée.

**12.** Procédé suivant la revendication 10 ou 11,
dans lequel le niveau de la tension est réglé au moyen d'une source de tension variable de sorte que la tension résultant de la somme de la tension extérieure appliquée plus la tension de diffusion s'établissant de soi-même constitue encore une tension de blocage.

**13.** Procédé suivant l'une des revendications 10 à 12,
dans lequel la fréquence fr de résonance du résonateur BAW est déterminée sans tension appliquée ;
dans lequel on applique ensuite la tension et on la règle de façon à ce que la fréquence fr de résonance se modifie d'un montant $\Delta$f jusqu'à ce que la fréquence de résonance ait pris la valeur $f_0$ souhaitée, dans lequel on a :

$$\Delta f = (fr - f_0).$$

**14.** Procédé suivant l'une des revendications 10 à 13,
dans lequel, dans un composant, il est prévu une pluralité de résonateurs ($R_i$) travaillant à des fréquences $fr_{0i}$ de consigne différente ;
dans lequel pour des résonateurs de même type ayant des fréquences de résonance différentes dues, le cas échéant, à la fabrication, on règle par application d'une tension de réglage appropriée la fréquence de résonance à la valeur, respectivement, souhaitée.

15. Utilisation d'un résonateur suivant l'une des revendications 1 à 9 comme élément de réactance d'un filtre passe-bande constitué en technique de dérivation.

16. Utilisation d'un résonateur suivant l'une des revendications 1 à 9 comme générateur de fréquence réglable pour ce qui concerne la fréquence de résonance.

17. Utilisation d'un résonateur suivant l'une des revendications 1 à 9 comme capteur pour une grandeur physique influençant l'oscillation du résonateur.

18. Utilisation suivant la revendication 17,
dans laquelle la grandeur physique modifie la fréquence de résonance du résonateur et dans laquelle la fréquence de résonance du résonateur est réglée à nouveau par application d'une tension de réglage à la fréquence de résonance d'origine et dans laquelle le niveau de la tension de réglage est pris comme mesure de la valeur de la grandeur physique.

# FIG 1

# FIG 2

# FIG 3

# FIG 4

## FIG 5

-U

E2

- - - - - - - - - - - - - - - - - - 5

+ + + + + + + + + + + + + + + +

+U

2

+ + + + + + + + + + + + + + + +

- - - - - - - - - - - - - - - - - - 4

E1

-U

## FIG 6

-U

E2

- - - - - - - - - - - - - - - - - -

+ + + + + + + + + + + + + + + 7

+U

2

+ + + + + + + + + + + + + + + + 6

- - - - - - - - - - - - - - - - - -

E1

-U

## FIG 7

## FIG 8

# FIG 9

EP 1 405 410 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

* US 4719383 A

**In der Beschreibung aufgeführte Nicht-Patentliteratur**

* **K. M. LAKIN.** Microwave Symposium Digest. *IEEE MTT-S International,* 1995, 838-886